# EUROPÄISCHE PATENTSCHRIFT

(11) **EP 2 975 987 B1**
(45) Veröffentlichungstag und Bekanntmachung des Hinweises auf die Patenterteilung: **16.11.2016**
(21) Anmeldenummer: 14713793.9
(22) Anmeldetag: 21.03.2014
(51) Int. Cl.: A47J 43/07

(54) **ELEKTROMOTORISCH BETREIBBARE KÜCHENMASCHINE, DATENSPEICHERELEMENT UND KOMBINATION EINER ELEKTROMOTORISCH BETREIBBAREN KÜCHENMASCHINE MIT EINEM DATENSPEICHERELEMENT**
KITCHEN APPLIANCE OPERABLE BY ELECTRIC MOTOR, DATA MEMORY ELEMENT, AND COMBINATION OF A KITCHEN APPLIANCE OPERABLE BY ELECTRIC MOTOR AND A DATA MEMORY ELEMENT
ROBOT MÉNAGER POUVANT FONCTIONNER À L'AIDE D'UN MOTEUR ÉLECTRIQUE, ÉLÉMENT DE STOCKAGE DE DONNÉES ET COMBINAISON D'UN ROBOT MÉNAGER POUVANT FONCTIONNER À L'AIDE D'UN MOTEUR ÉLECTRIQUE AVEC UN ÉLÉMENT DE STOCKAGE DE DONNÉES

(30) Priorität: 21.03.2013 DE 102013102919
(43) Veröffentlichungstag der Anmeldung: 27.01.2016
(60) Teilanmeldung: 16158428.9
(73) Patentinhaber: Vorwerk & Co. Interholding GmbH, 42275 Wuppertal (DE)
(72) Erfinder: HACKERT, Georg, 44869 Bochum (DE); JACOBS, Carsten, 42477 Radevormwald (DE); LANG, Torsten, 42657 Solingen (DE)
(74) Vertreter: Müller, Enno
(86) Internationale Anmeldenummer: PCT/EP2014/055710
(87) Internationale Veröffentlichungsnummer: WO 2014/147223

(56) Entgegenhaltungen:
- WO-A1-2008/112066
- US-A1- 2002 009 017
- US-A1- 2008 223 854

## Beschreibung

Die Erfindung betrifft zunächst eine elektromotorisch betreibbare Küchenmaschine mit einem eine Außenfläche aufweisenden Gehäuse und einer zur Zusammenwirkung mit einem Datenspeicherelement ausgebildeten Datenübertragungs-Schnittstelle.

Die Erfindung betrifft des Weiteren ein Datenspeicherelement zum Übertragen von Daten auf eine elektromotorisch betreibbare Küchenmaschine mit mehreren voneinander gesonderten Kontaktflächen.

Die Erfindung betrifft auch eine Kombination einer elektromotorisch betreibbaren Küchenmaschine mit einem lösbar mit der Küchenmaschine verbindbaren Datenspeicherelement, dessen Daten in einem mit der Küchenmaschine verbundenen Zustand an die Küchenmaschine übertragbar sind, wobei die Küchenmaschine ein eine Außenfläche aufweisendes Gehäuse und eine zur Zusammenwirkung mit dem Datenspeicherelement ausgebildete Datenübertragungs-Schnittstelle aufweist.

Es ist allgemein bekannt, an Maschinen Daten zu übertragen, oftmals mittels einer als USB-Schnittstelle ausgebildeten Datenübertragungs-Schnittstelle. Diese Schnittstellen erfordern eine in das Innere einer Maschine oder eines Gerätes reichende lochartige Ausgestaltung. Sie sind im Hinblick auf eine Küchenmaschine mit Nachteilen verbunden, da sich eine Verschmutzung ergeben kann und eine lochartige Ausgestaltung, als notwendige Einschuböffnung, sich zusetzen kann.

Aus der US 2002/0009017 A1 ist ein Datenspeicherelement bzw. eine Küchenmaschine mit einem Datenspeicherelement bekannt, wobei das Datenspeicherelement als rechteckiges Flachteil ausgebildet ist. Das Flachteil ist insgesamt quaderförmig, mit geraden Seitenkanten ausgebildet. Im in die Küchenmaschine eingesteckten Zustand ist das Datenspeicherelement unterseitig der Küchenmaschine angeordnet.

Die US 2008/0223854 A1 zeigt eine übliche Knopfausbildung. Es sind seitliche Kontaktelemente vorgesehen.

Ausgehend von einem Stand der Technik gemäß der US 2002/0009017 A1 beschäftigt sich die Erfindung mit der Aufgabe, eine elektromotorisch betreibbare Küchenmaschine mit einer günstigen Datenübertragungs-Schnittstelle anzugeben, darüber hinaus ein Datenspeicherelement, das insbesondere im Hinblick auf Handhabungsanforderungen, insbesondere bezüglich Küchenmaschinen, günstig ausgestaltet ist und eine Kombination einer elektromotorisch betreibbaren Küchenmaschine mit einem Datenspeicherelement, die günstig zusammenwirken können.

Diese Aufgabe ist hinsichtlich der elektromotorisch betreibbaren Küchenmaschine dadurch gelöst, dass die Datenübertragungs-Schnittstelle in einer Außenfläche des Gehäuses durch nebeneinander angeordnete metallische, jeweils eine Kontaktfläche aufweisende und jeweils einen Teil der Außenfläche darstellende Kontaktelemente gebildet ist. Die einen Teil der Außenfläche darstellenden Kontaktflächen ersparen es, lochartige, in das Innere der Küchenmaschine ragende Stecköffnungen vorzusehen. Im Hinblick auf eine Küchenmaschine ergibt sich entsprechend eine gute Reinigbarkeit auch eines solchen Teils der Außenfläche. Die Kontaktelemente sind in die Außenfläche integriert nebeneinander angeordnet. Bevorzugt ist die Ausgestaltung so geschaffen, dass bei Projektion der Außenfläche in eine, bezogen auf eine übliche Aufstellung der Küchenmaschine, vertikale oder horizontale Ebene, wie auch eine nach Zeichnungsregeln erstellte Draufsicht oder Seitenansicht einer Küchenmaschine bezogen auf deren übliche Aufstellung auf einem ebenen Untergrund erstellt wird, sich sämtliche Kontaktflächen nebeneinander abbilden.

In ihrer technischen Funktion entspricht die Datenübertragungs-Schnittstelle bevorzugt einer üblichen Schnittstelle, wie sie für USB-Sticks beispielsweise geräteseitig bekannt ist.

Hinsichtlich des Datenspeicherelementes ist die Aufgabe dadurch gelöst, dass die jeweils eine Kontaktfläche aufweisenden Kontaktelemente jeweils einen Teil der Anlagefläche bilden und dass in der Anlagefläche auch, gesondert von den Kontaktelementen, ein oder mehrere Magnete wirken oder ein oder mehrere magnetisierbare Bereiche ausgebildet sind. Auch hierbei ist gegeben, dass sich die Kontaktelemente, bezogen auf eine Darstellung der Unterseite nach den angesprochenen Zeichnungsregeln, nebeneinander abbilden. Die Unterseite ist hierbei in Bezug auf die Ebene, auf welche gedanklich projiziert wird, so ausgerichtet, dass die Kontaktelemente, die auch bevorzugt in einer gemeinsamen Ebene angeordnet sind, sich in ihrer Flächenerstreckung in einer parallel versetzten Ebene befinden. Für die hier vorrangig verfolgte Verdeutlichung der Nebeneinander-Anordnung kommt es aber ersichtlich nicht auf eine geometrisch vollkommen exakte Ausrichtung an, wenn diese auch bevorzugt ist.

So ist erreicht, dass das Datenspeicherelement eine zu der Außenfläche der beispielsweise Küchenmaschine passende Anlagefläche aufweist, die in flächigem Kontakt mit der Außenfläche des Gerätes, auf welches Daten zu übertragen sind, in unmittelbare Anlage kommen kann. Dadurch, dass ein oder mehrere Magnete oder magnetisierbare Bereiche ausgebildet sind, ist auch eine günstige Halterungsmöglichkeit des Datenspeicherelementes zugleich kombiniert in diesem vorgesehen.

Ein solches Datenspeicherelement ist auch bevorzugt in seiner technischen Funktion entsprechend einem üblichen USB-Stick ausgebildet. Es kann auch noch Zusatzfunktionen aufweisen, wie etwa eine Verschlüsselungseinrichtung, insbesondere durch einen hierfür in dem Datenspeicherelement vorgesehenen Kryptospeicher. Es können auch Bauelemente zur Ausgestaltung von Funkübertragungsmöglichkeiten zur Datenübermittlung an das Datenspeicherelement vorgesehen sein, etwa solche, wie sie zur Übertragung nach dem UMTS-Standard erforderlich sind.

Hinsichtlich einer Kombination einer elektromotorisch betreibbaren Küchenmaschine und einem lösbar mit der Küchenmaschine verbindbaren Datenspeicherelement ist eine weitere mögliche Lösung der Aufgabe dadurch gegeben, dass die Datenübertragungs-Schnittstelle in der Außenfläche des Gehäuses der Küchenmaschine durch nebeneinander angeordnete metallische, jeweils eine Kontaktfläche aufweisende und hiermit jeweils einen Teil der Außenfläche darstellende Kontaktelemente gebildet ist und dass das Datenspeicherelement eine zur flächigen Anlage an die Datenübertragungs-Schnittstelle der Küchenmaschine dienende und hieran angepasste Anlagefläche aufweist. In der Anlagefläche können auch, gesondert von den Kontaktelementen, ein oder mehrere Magnete wirken oder ein oder mehrere magnetisierbare Elemente ausgebildet sein. Auch können in der Außenfläche der Küchenmaschine, zugeordnet der Datenübertragungs-Schnittstelle, ein oder mehrere Magnete wirken, zur Zusammenwirkung mit den magnetisierbaren Elementen des Datenspeicherelementes im verbundenen Zustand, oder können in der Außenfläche, zugeordnet der Datenübertragungs-Schnittstelle, ein oder mehrere magnetisierbare Elemente vorgesehen sein, zur Zusammenwirkung im verbundenen Zustand mit Magneten des Datenspeicherelementes.

Somit ist eine günstig in die Küchenmaschine integrierte Datenübertragungs-Schnittstelle geschaffen, kombiniert mit einem hieran angepassten Datenspeicherelement. Durch Magnetverhaftung kann zudem eine einfache Verbindung und Lösung der Küchenmaschine und des Datenspeicherelementes erreicht werden.

Eine weitere Lösung der Aufgabe hinsichtlich der Kombination der Küchenmaschine mit einem Datenspeicherelement ist auch dadurch gegeben, dass das Datenspeicherelement als Flachteil mit einer Unterseite und einer Oberseite ausgebildet ist, mit einer größten Grundrissabmessung der Unterseite beziehungsweise der Oberseite, die dem 1,5-Fachen oder mehr der größten Dicke des Datenspeicherelementes entspricht, bis hin beispielsweise zu einem 10- oder 20-Fachen, wobei Kontaktelemente in der Küchenmaschine als erste Kontaktelemente und Kontaktelemente des Datenspeicherelementes als zweite Kontaktelemente angesprochen sind und die zweiten Kontaktelemente in der Unterseite des Datenspeicherelementes angeordnet sind und dass bei mit der Küchenmaschine zur Datenübertragung zusammenwirkendem Datenspeicherelement in einem Ansichtskegel mit einem Kegelwinkel von 60° oder weniger, bezogen auf eine Kegelachse senkrecht zu einer Mittelebene des Datenspeicherelementes und den Flächenmittelpunkt durchsetzend, nur die Oberseite sichtbar ist. Die Ausbildung des Datenspeicherelementes als Flachteil ist dazu genutzt, das Datenspeicherelement gleichsam integrierend in die Außenfläche der Küchenmaschine im Zustand der Datenübertragung anzuordnen. Zwar kann das Datenspeicherelement gegenüber einer umgebenden Außenfläche des Gehäuses im Bereich der Datenübertragungs-Schnittstelle der Küchenmaschine eine gewisse Erhebung darstellen. Eine Ausrichtung der Oberseite ist aber angepasst an die Ausrichtung der umgebenden Gehäusefläche.

Bezüglich der Küchenmaschine ist bevorzugt, dass die Datenübertragungs-Schnittstelle in einer Teil-Außenfläche ausgebildet ist, die gegenüber der umgebenden Außenfläche der Küchenmaschine zurückversetzt ist. Sie ist zum Inneren der Küchenmaschine hin versetzt. Durch die gebildete Teil-Außenfläche und deren Zurückversetzung ist zugleich bevorzugt eine Aufnahmemulde gebildet für das Datenspeicherelement oder für zumindest einen Teil des Datenspeicherelementes. Die Aufnahmemulde kann günstig zur Halterung des Datenspeicherelementes in einem mit der Küchenmaschine verbundenen Zustand beitragen. Das Datenspeicherelement schließt mit seiner Oberseite im mit der Küchenmaschine verbundenen Zustand mit der umgebenden Außenfläche der Küchenmaschine ab oder erhebt sich über diese.

Die Aufnahmemulde weist einen Muldenboden auf. Eine Erstreckung des Muldenbodens ist bevorzugt an die Erstreckung der umgebenden Außenfläche der Küchenmaschine angepasst. Es handelt sich insofern gleichsam um einen ebenflächig zum Inneren der Küchenmaschine hin versetzten Bereich der Außenfläche.

Die Mulde kann derart gebildet sein, dass das Datenspeicherelement zugleich im aufgenommenen Zustand durch eine Muldenwandung allein gehalten ist, dies zumindest so weit, dass es bei einer Freiheit von Erschütterungen nicht zu einem Herabfallen oder Ausfallen des Datenspeicherelementes aus der Mulde kommt, auch wenn die Teil-Außenfläche senkrecht oder in einem spitzen Winkel zu einer Senkrechten (wiederum bezogen auf eine übliche Aufstellungssituation der Küchenmaschine auf ebenem Untergrund) gebildet ist.

Bevorzugt ist jedoch, dass das Datenspeicherelement ohne zusätzliche Maßnahmen, wie nachstehend noch in weiterer Einzelheit erläutert, in der Mulde jedenfalls bei deren senkrechter oder nahezu senkrechter Ausrichtung hinsichtlich der Teil-Außenfläche, nicht gehalten ist, also keine Datenübertragung stattfinden kann.

Die Größe der Mulde hinsichtlich ihrer Flächenerstreckung kann bevorzugt derart gegeben sein, dass ein oder mehrere, mit einem Reinigungstuch beispielsweise überzogene Finger sich zum Reinigen über die Teil-Außenfläche bewegen können. Die Zurückversetzung ist bevorzugt gegenüber einer gedanklichen Fortsetzung der umgebenden Außenfläche in ihrem tiefsten Bereich um wenige Millimeter gegeben, beispielsweise 3 bis 20 mm.

Das Datenspeicherelement kann bevorzugt eine an die Mulde geometrisch angepasste Gestaltung aufweisen, bezüglich des im Kontaktzustand in die Mulde eingetauchten Bereiches, so dass sich im Wesentlichen über die gesamte in die Mulde im Kontaktzustand eingetauchte Oberfläche des Datenspeicherelementes ein Anlegen an die Muldenwandung ergibt. Der in die Mulde im Kontaktzustand eingetauchte Bereich ist bevorzugt allein durch die Unterseite des Datenspeicherelementes gegeben. Hierbei kann die Unterseite vollständig, teilweise, oder bevorzugt jedenfalls überwiegend, in die Mulde im Kontaktzustand eingetaucht sein.

Randseitig geht die Unterseite im Querschnitt in eine Wandungskontur über, die sich rechtwinklig oder in einem stumpfen Winkel von beispielsweise 91 bis 160° zu der Konturlinie der Unterseite, jedenfalls der dem Randbereich zugeordneten Abschnitt der Konturlinie, erstreckt. Auch die Oberseite geht randseitig in dem genannten Querschnitt in eine sich nach unten erstreckende Wandungskontur über, die in gleicher Weise rechtwinklig oder in einem stumpfen Winkel, beispielsweise 91 bis 160° zu der Konturlinie der Oberseite, jedenfalls in dem dem Rand zugeordneten Bereich, verläuft. Entsprechend ergibt sich im Zusammentreffen der beiden Wandkonturlinien, wenn der genannte stumpfe Winkel verwirklicht ist, eine umlaufende Kante, die zum Ergreifen des Datenspeicherelementes günstig ist. Die Kante ist bezüglich einer Dicke des Datenspeicherelementes, gemessen in dem Querschnitt zwischen der Unterseite und der Oberseite, außermittig angeordnet, nämlich bevorzugt versetzt zu der Oberseite hin.

Die Mulde kann - bezogen auf einen Querschnitt - vom Muldenboden sich nach außen, zum Übergang in die umgebende Außenfläche des Gehäuses erstreckende Muldenwandungen aufweisen. Es kann sich um eine umlaufende und bevorzugt geschlossen ausgebildete Muldenwandung handeln. Eine Muldenwandung kann in ihrer Erstreckung - bezogen auf den Querschnitt - bevorzugt einen stumpfen Winkel mit dem Muldenboden einschließen, weiter bevorzugt zwischen 91 und 160°.

Das Datenspeicherelement kann sich unabhängig von oder ergänzend zu Vorstehendem auch dadurch auszeichnen, dass es als Flachteil mit einer Unterseite und einer Oberseite ausgebildet ist, mit einer größten Grundrissabmessung der Unterseite beziehungsweise der Oberseite, die dem 1,5-Fachen oder mehr, bis hin zu 10- oder 20-Fachen, einer größten Dicke des Datenspeicherelementes entspricht und dass die Kontaktelemente in einer der Seiten, in der Unterseite, angeordnet sind.

Die untere Seite ist entsprechend die Seite, die im Zusammenwirkungszustand mit der Küchenmaschine unmittelbar auf einer entsprechenden Fläche, bevorzugt der genannten Teil-Außenfläche, aufliegt. Die flache Ausbildung, bevorzugt auch mit einem abgerundeten oder weiter bevorzugt mit einem kreisförmigen Grundriss, mit der Anordnung der Kontaktelemente in einer der Flachseiten, ermöglicht eine Handhabung durch einfaches Auflegen der vergleichsweise großen Unterseite auf die entsprechende Auflagefläche, insbesondere die Teil-Außenfläche, der Küchenmaschine. Es muss kein Einsteckvorgang vorgenommen werden.

Hinsichtlich der elektromotorisch betreibbaren Küchenmaschine ist bevorzugt in weiterer Ausgestaltung vorgesehen, dass die Teil-Außenfläche geschlossen ausgebildet ist. Es handelt sich um eine insbesondere öffnungs- und lochfreie Teil-Außenfläche.

Die Teil-Außenfläche kann insbesondere im Bereich der metallischen Kontaktelemente eine gewisse Erhebung oder Versenkung aufweisen. Die metallischen Kontaktelemente können sich hierbei über einen umgebenden Bereich der Teil-Außenfläche (gegebenenfalls auch als Muldenboden anzusprechen) nach außen um ein ihrer größten Erstreckung entsprechendes Maß oder weniger erheben oder um ein solches Maß gegenüber der Ebene beziehungsweise dem die metallischen Kontaktelemente umgebenden Bereich (gegebenenfalls auch als Muldenboden anzusprechen) zurückversetzt sein. Absolut kann das Maß beispielsweise zwischen 0,5 und 5 mm liegen. Im Falle einer Erhebung ist dieses aber bevorzugt geringer als es einer absoluten Versetzung (nach innen) der Teil-Außenfläche entspricht.

Die metallischen Kontaktelemente sind bevorzugt zusammengefasst in einer rippenartigen Erhöhung des Muldenbodens angeordnet.

Sie können sich auch in der Ebene der Teil-Außenfläche beziehungsweise zumindest des unmittelbar umgebenden Bereiches (im Falle etwa der genannten Rippenausbildung) erstrecken.

Im Einzelnen können drei oder mehr metallische Kontaktelemente vorgesehen sein. Hierbei ist auch bevorzugt, dass diese metallischen Kontaktelemente entlang einer Geraden angeordnet sind. Dies kann sowohl an der Küchenmaschine wie an dem Datenspeicherelement entsprechend vorgesehen sein. Bevorzugt sind die Ausbildungen betreffend die Kontaktelemente, die Anlagefläche und/oder die Mulde ohnehin gleichsam spiegelbildlich an der Küchenmaschine beziehungsweise dem Datenspeicherelement vorgesehen.

Die Teil-Außenfläche weist einen Flächenmittelpunkt auf, der auch als geometrischer Schwerpunkt bezeichnet wird. Bei einer kreisförmigen Teil-Außenfläche, deren Grundriss entsprechend durch eine Kreislinie begrenzt ist, ist der Flächenmittelpunkt der Mittelpunkt dieses Kreises.

Bezüglich eines solchen Flächenmittelpunktes ist bevorzugt, dass die metallischen Kontaktelemente außerhalb des Flächenmittelpunktes angeordnet sind. Bei einer kreisförmigen Grundrisskontur können die metallischen Kontaktelemente auf einer eine Sekante zu der diesbezüglichen Kreisfläche bildenden Linie angeordnet sein.

Die Teil-Außenfläche weist bevorzugt zumindest eine Rundungen aufweisende Grundrisskontur auf. Sie kann, wie angemerkt, im Speziellen kreisförmig oder beispielsweise oval sein.

Die Teil-Außenfläche ist gegenüber der Gesamt-Außenfläche der Küchenmaschine beziehungsweise einer Seite der Küchenmaschine, in welche sie integriert ist, vergleichsweise klein. Absolut gesehen, kann die Teil-Außenfläche eine Dimension aufweisen, bei welcher eine größte lineare Erstreckung, gegebenenfalls ein Durchmessermaß, innerhalb der Grundrisskontur 1 bis 10 cm beträgt.

Weiter bevorzugt sind ein oder mehrere in der Außenfläche oder in der Teil-Außenfläche wirksame Magnete oder magnetisierbare Bereiche vorgesehen. Ein Magnet oder magnetisierbarer Bereich kann seitlich versetzt zu einem metallischen Kontaktelement vorgesehen sein. Bevorzugt sind sie seitlich versetzt zu einer gedachten Verbindungslinie der Kontaktelemente zum Flächeninneren beziehungsweise zum Flächenmittelpunkt der Teil-Außenfläche hin. Insbesondere ist bevorzugt, dass ein Magnet oder ein magnetisierbare Bereich unterhalb der Teil-Außenfläche, jedoch in dieser wirkend, angeordnet ist, weiter bevorzugt derart, dass er von außen nicht sichtbar ist. Während die Teil-Außenfläche, wie auch die Außenfläche der Küchenmaschine bevorzugt im Übrigen, oder jedenfalls im Wesentlichen im Übrigen, aus Kunststoff gebildet ist, ist natürlicherweise der Magnet oder der magnetisierbare Bereich metallisch ausgebildet.

Insbesondere ist bevorzugt, dass zwei Magnete oder zwei magnetisierbare Bereiche vorgesehen sind.

Ein Abstand zwischen den Magneten oder den magnetisierbaren Bereichen ist bevorzugt größer als ein Abstand zwischen zwei äußersten von nebeneinander angeordneten metallischen Kontaktelementen. Insbesondere sind die Magnete oder magnetisierbaren Bereiche nahe an oder teilweise zusammenfallend mit einer Grundrisskontur der Teil-Außenfläche angeordnet. Im Hinblick auf ein hierin anordbares Datenspeicherelement ergibt sich so, bezogen auf die Gesamtfläche, eine größtmögliche "Hebelwirkung" zur Ausrichtung des Datenspeicherelementes beim Einsetzen.

Die Teil-Außenfläche weist in einem Querschnitt bevorzugt einen ebenflächigen Bodenbereich und ansteigende Randbereiche auf, wobei die Randbereiche weiter bevorzugt einer Krümmungslinie, beispielsweise einer Teil-Kreislinie folgend, ausgebildet sind. Auch der Übergang in die umgebende Außenfläche der Küchenmaschine ist bevorzugt gerundet ausgebildet.

Hinsichtlich des Datenspeicherelementes ist weiter bevorzugt, dass die umgebende Anlagefläche, in welcher die Kontaktflächen ausgebildet sind, praktisch höhengleich zu den Kontaktflächen ist. Im Einzelnen können die Kontaktflächen auch leicht versetzt, bevorzugt im Sinne einer Vertiefung, gegenüber der umgebenden Anlagefläche angeordnet sein. Die Versenkung kann hierbei im absoluten Maß etwa 0,5 bis 5 mm entsprechen.

Das Datenspeicherelement selbst weist hinsichtlich der Anlagefläche, die im Zusammenhang vorliegender Anmeldung auch als Unterseite bezeichnet ist, bevorzugt eine gerundete Kontur auf, beispielsweise eine kreisförmige oder ovalförmige Kontur. Hierbei ist die Anlagefläche, gegebenenfalls mit Ausnahme der Kontaktelemente, soweit diese der Anlagefläche gegenüber in der beschriebenen Weise erhaben oder versenkt angeordnet ausgebildet sind, ebenflächig gestaltet, mit einem Randbereich, der im Querschnitt gerundet verläuft, und zwar derart, dass der ebenflächige Bereich der Anlagefläche vorstehend ist. Die Ausmaße der Anlagefläche entsprechen den vorstehend angegebenen Ausmaßen der Teil-Außenfläche. Das Datenspeicherelement ist in Erstreckungsrichtung der Anlagefläche bevorzugt deutlich größer als quer hierzu. Es ist weiter bevorzugt als diskusartiger Körper gestaltet, wobei mit dieser Bezeichnung aber nicht zwingend eine kreisförmige Grundrisskontur vorgegeben ist. Die größte Dicke des Datenspeicherelementes entspricht bevorzugt einem Drittel bis einem Zwanzigstel der größten linearen Erstreckung bezogen auf eine Grundrisskontur des Datenspeicherelementes, bei dem ein Zustand abgenommen ist, bei welchem das Datenspeicherelement auf der Anlagefläche aufliegend auf einem ebenen Untergrund angenommen ist.

Das Datenspeicherelement kann einen nicht flüchtigen Speicher aufweisen. Es kann weiter einen Kryptospeicher aufweisen. Es kann darüber hinaus Elemente zur drahtlosen Datenübertragung, etwa Funkübertragung, aufweisen, so beispielsweise Elemente, wie sie für einen UMTS-Empfang erforderlich sind.

Das Datenspeicherelement weist weiter bevorzugt eine Griffausformung auf. Die Griffausformung kann in einem auf einer Seite, im Sinne obiger Ausführungen der Oberseite, ausgebildeten im Wesentlichen senkrecht abstehenden Grifffortsatz bestehen, etwa im Sinne einer Griffausformung an einem Stempel. Bevorzugt ist jedoch, dass die Griffausformung sich durch eine Randkontur des Datenspeicherelementes ergibt. Hierzu ist die Unterseite so ausgebildet, dass die durch den Übergang der Unterseite in die Oberseite gegebene Randkontur im Zusammenwirkungszustand des Datenspeicherelementes mit der Küchenmaschine über die Außenfläche der Küchenmaschine übersteht, so dass das Datenspeicherelement hierzu greifbar ist.

Im Weiteren ist von Bedeutung, dass durch die versetzte Anordnung der Magnete/magnetisierbaren Bereiche relativ zu den Kontaktelementen, insbesondere bezüglich der im Einzelnen in einem erhabenen beziehungsweise versenkten Bereich angeordneten Kontaktelemente sich ein Einfang-Effekt des Datenspeicherelementes auf der Außenfläche, insbesondere in der Mulde, ergibt, so dass zur Zusammenfügung von Datenspeicherelement und Küchenmaschine im Hinblick auf einen Datenaustausch ein Benutzer nur eine grobe Vorausrichtung des Datenspeicherelementes bezüglich der Außenfläche beziehungsweise der Teil-Außenfläche der Küchenmaschine vornehmen muss und sich das Datenspeicherelement sodann durch die Magnetwirkung einerseits und eine zentrierende Einfügung des rippenartigen Vorsprungs in die entsprechende Ausnehmung andererseits selbst in die tatsächliche Kontaktposition manövriert. Hierzu ist es auch bevorzugt, dass der genannte rippenartige Vorsprung beziehungsweise die entsprechende Ausnehmung auf der Küchenmaschine, beziehungsweise in dem Datenspeicherelement, im Querschnitt gerundete Übergänge, mit einem stumpfen Winkel zwischen der unmittelbar umgebenden Außenfläche (Teil-Außenfläche) und einem Querschnittsverlauf der Wandung des rippenartigen Vorsprungs (analog bei der Ausnehmung) aufweisen. Der stumpfe Winkel kann zwischen 91 und 160° betragen. Bevorzugt ist bezüglich des rippenartigen Vorsprungs und der Ausnehmung ein solcher Winkel sowohl an den längsrandseitigen ansteigenden Flächen des rippenartigen Vorsprungs wie an den stirnseitigen Flächen des rippenartigen Vorsprungs ausgebildet.

Durch die in der Fläche versetzte Anordnung der Magnete beziehungsweise der magnetisierbaren Bereiche, einerseits, und dem rippenartigen Vorsprung oder die entsprechende Einsenkung, andererseits, ergibt sich beim ungerichteten Anlegen des Datenspeicherelementes an den entsprechenden Bereich der Küchenmaschine eine gewisse Einweiser-Hebelwirkung, die dann selbsttätig das Datenspeicherelement in die letztlich präzise Kontaktstellung zieht beziehungsweise bewegt.

Das Datenspeicherelement weist bevorzugt mit Ausnahme der beschriebenen nebeneinander angeordneten, jeweils einen Teil der Außenfläche bildenden Kontaktelemente keine weiteren in der Außenfläche liegenden oder von der Außenfläche ausgehenden (etwa nachstehend beschriebene übliche USB-Schnittstellen) Kontaktelemente auf.

Im Hinblick auf das Datenspeicherelement kann aber auch vorgesehen sein, dass es zusätzlich zu den beschriebenen, in der Außenfläche angeordneten Kontaktelementen - in einer der aufgezeigten Ausgestaltungen - als weitere Kontaktelemente solche einer üblichen USB-Schnittstelle aufweist. Eine solche USB-Schnittstelle ist lochartig in das Innere des Datenspeicherelements gerichtet. Die so gegebenenfalls vorgesehene übliche USB-Schnittstelle kann in einer Seitenfläche ausgebildet sein. Die Seitenfläche ist hierbei die zwischen den Ebenen der Unterseite und Oberseite ausgebildete Fläche. Hinsichtlich der bevorzugt im Grundriss kreisrunden Gestaltung des Datenspeicherelementes kann diese USB-Schnittstelle entsprechend nahezu beliebig am Umfang vorgesehen sein. Es können auch mehrere derartige übliche USB-Schnittstellen in beispielsweise der genannten Seitenfläche vorgesehen sein.

Darüber hinaus kann diese USB-Schnittstelle, gerichtet in das Innere des Datenspeicherelementes, auch ausgehend von der Ober- und/oder Unterseite vorgesehen sein. Auch können grundsätzlich mehrere übliche USB-Schnittstellen in dieser Weise ausgebildet sein.

Um ein Verschmutzungsproblem so gering wie möglich zu halten, kann eine solche übliche USB-Schnittstelle mit einem Verschlussteil versehen sein, etwa einem Verschlussteil, das stopfenartig ausgebildet ist. Weiter bevorzugt auch mit einem Verschlussteil, das mit einem gesonderten Werkzeug (nur) öffenbar ist.

Eine solche übliche USB-Schnittstelle kann dazu dienen, im ausgewählten Betriebszustand, beispielsweise insbesondere dann, wenn das Datenspeicherelement nicht mit der Küchenmaschine verbunden ist, dieses zur Übertragung von Daten an einen üblichen Rechner, etwa einen Standcomputer oder tragbaren Computer oder einen Tablett-Computer anzuschließen.

Die genannte übliche USB-Schnittstelle kann in weiterer Einzelheit eine Standard USB-Schnittstelle sein. Hierzu kennt man beispielsweise die Schnittstelle USB 2.0 Standard-A, die Schnittstelle USB 3.0 Standard-A, die Schnittstelle 3.0 Powered-B, die Schnittstelle USB 3.0 Standard-B, die Schnittstelle USB 2.0 Standard-B, die Schnittstelle USB 2.0 Mini-B, die Schnittstelle USB 3.0 Micro-AB, die Schnittstelle USB 2.0 Micro-AB, die Schnittstelle USB 3.0 Micro-B, die Schnittstelle USB 2.0 Micro-B etc.

Hinsichtlich der Kombination der elektromotorisch betreibbaren Küchenmaschine mit dem Datenspeicherelement ist bevorzugt, dass die Küchenmaschine und/oder das Datenspeicherelement mit einem oder mehreren der vorstehend diesbezüglich erläuterten Merkmale ausgebildet ist.

Die vor- und nachstehend angegebenen Bereiche beziehungsweise Wertebereiche oder Mehrfachbereiche schließen hinsichtlich der Offenbarung auch sämtliche Zwischenwerte ein, insbesondere in 1/10- Schritten der jeweiligen Dimension, gegebenenfalls also auch dimensionslos; beispielsweise beträgt ein Schritt ein Zehntel einer Länge, Breite etc. oder eines x-Fachen; wenn weiter beispielsweise ein Bereich (für eine Länge) mit einem drei bis fünffachen (einer Breite) angegeben ist, ist auch offenbart das 3,1- bis 5-Fache, das 3- bis 4,9-Fache, das 3,1- bis 4,9-Fache, das 3,2- bis 5-Fache etc., d.h. einerseits zur Eingrenzung der genannten Bereichsgrenzen von unten und/oder oben, alternativ oder ergänzend aber zur Offenbarung eines oder mehrerer singulärer Werte aus einem jeweils angegebenen Bereich. Bezüglich beispielsweise eines Bereiches von 0,5 bis 5 mm (Länge, Breite etc.) ist dann auch offenbart, 0,6 bis 5 mm, 0,6 bis 4,9 mm, 0,5 bis 4,9 mm etc. Bezüglich eines Winkelbereiches von beispielsweise 91 bis 160° ist somit auch ein Bereich von 91,1 bis 160°, 91 bis 159,9°, 91,1 bis 159,9° etc. offenbart, sowie auch diesbezügliche Einzelwerte als Bereichsgrenzen oder innerhalb des Bereiches.

Nachstehend ist die Erfindung des Weiteren anhand der beigefügten Zeichnung, die jedoch lediglich ein Ausführungsbeispiel darstellt, erläutert. Hierbei zeigt:
- Fig. 1: eine perspektivische Gesamtansicht einer Küchenmaschine mit zugeordnetem Datenspeicherelement;
- Fig. 2: den Bereich der Teil-Außenfläche in Vergrößerung;
- Fig. 3: eine Darstellung gemäß Figur 2, mit eingesetztem Datenspeicherelement;
- Fig. 4: einen Querschnitt durch die Küchenmaschine geschnitten entlang der Linie IV-IV in Figur 3;
- Fig. 5: eine perspektivische Ansicht des Datenspeicherelementes, gesehen auf die Unterseite;
- Fig. 6: eine Querschnittsdarstellung des Datenspeicherelementes, geschnitten entlang der Linie VI-VI in Figur 5;
- Fig. 7: eine Explosionsdarstellung des Datenspeicherelementes, gesehen von schräg oben;
- Fig. 8: eine Explosionsdarstellung des Datenspeicherelementes, gesehen von schräg unten; und
- Fig. 9: eine Darstellung des Datenspeicherelementes entsprechend Figur 6, mit angedeuteten einer oder mehreren zusätzlichen üblichen USBSchnittstellen.

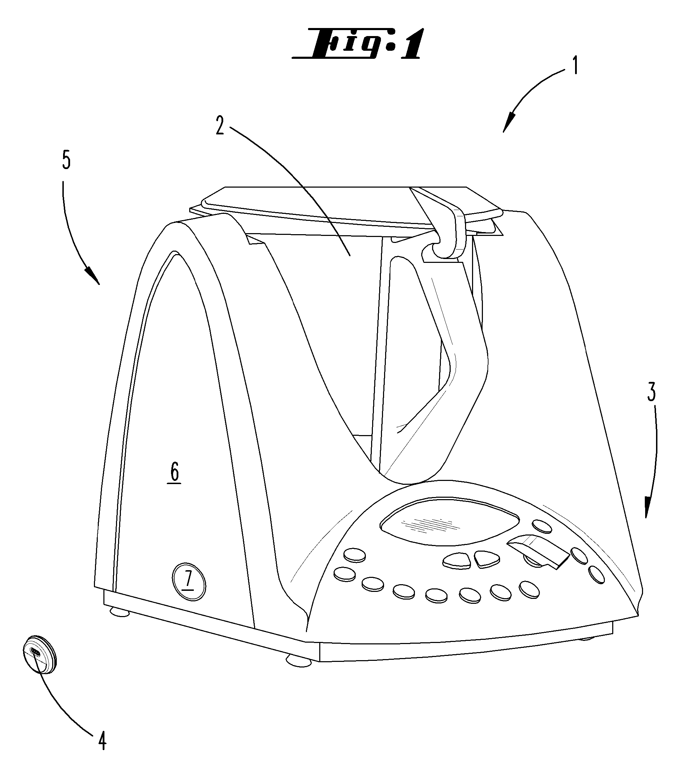

Dargestellt und beschrieben ist eine Küchenmaschine 1, die über einen nicht dargestellten, innerhalb der Küchenmaschine 1 befindlichen Elektromotor betreibbar ist. Die Küchenmaschine 1 weist weiter ein darin aufnehmbares, bei der Darstellung der Figur 1 aufgenommenes, Rührgefäß 2 auf und ein Bedienfeld 3.

Weiter ist in der Küchenmaschine 1 eine Steuerungseinrichtung vorgesehen für ein innerhalb des Rührgefäßes 2 betreibbares Rührwerk, und bevorzugt eine Aufheizeinrichtung zum Aufheizen des Rührgefäßes 2.

Weiter weist die Küchenmaschine einen Datenspeicher auf und einen Mikroprozessor. Darüber hinaus ist bevorzugt noch ein weiterer Datenspeicher vorgesehen, zur Aufnahme von Daten, die über ein Datenspeicherelement eingebracht werden können. Das Datenspeicherelement 4 ist lösbar an der Küchenmaschine 1 halterbar. In Figur 1 ist das Datenspeicherelement 4 losgelöst von der Küchenmaschine und gesehen auf die nachstehend als Unterseite angesprochene Fläche dargestellt. Eine Datenübertragung von dem Datenspeicherelement 4 ist zunächst bevorzugt in dem genannten weiteren Datenspeicher der Küchenmaschine vorgesehen. Ergänzend oder alternativ auch in dem zunächst genannten in der Küchenmaschine ohnehin vorhandenen Datenspeicher.

Im Einzelnen weist die Küchenmaschine 1 ein Gehäuse 5 auf, mit einer Außenfläche 6. In weiterer Einzelheit ergeben sich bei strenger Betrachtung der Küchenmaschine von vorne, hinten und der Seite, vier zu unterscheidende Außenflächen 6. In einer der Außenflächen 6, hier bevorzugt einer Seiten-Außenfläche, ist eine Teil-Außenfläche 7 ausgebildet. Die Teil-Außenfläche 7 stellt einen gegenüber der umgebenden Außenfläche 6 zum Inneren der Küchenmaschine 1 hin versetzten Bereich dar. Ersichtlich ist die Teil-Außenfläche 7 gegenüber der umgebenden Außenfläche 6 klein. Sie entspricht weniger als der Hälfte, bevorzugt weniger als einem Drittel, weiter bevorzugt weniger als einem Zehntel der umgebenden Außenfläche 6, hierbei bezogen auf eine Seitenfläche im angegebenen Sinne, beispielsweise bis hin zu einem Fünfzigstel.

Eine Seiten-Außenfläche der Küchenmaschine ist insbesondere eine Fläche, die sich in der weiter vorne beschriebenen Weise auf eine gedachte vertikale Fläche im Hinblick auf eine nach üblichen Zeichenregeln gefertigte Ansicht projizieren lässt. Hinsichtlich einer Oberseite einer Küchenmaschine handelt es sich entsprechend um eine darüber befindliche horizontale (gedachte) Fläche.

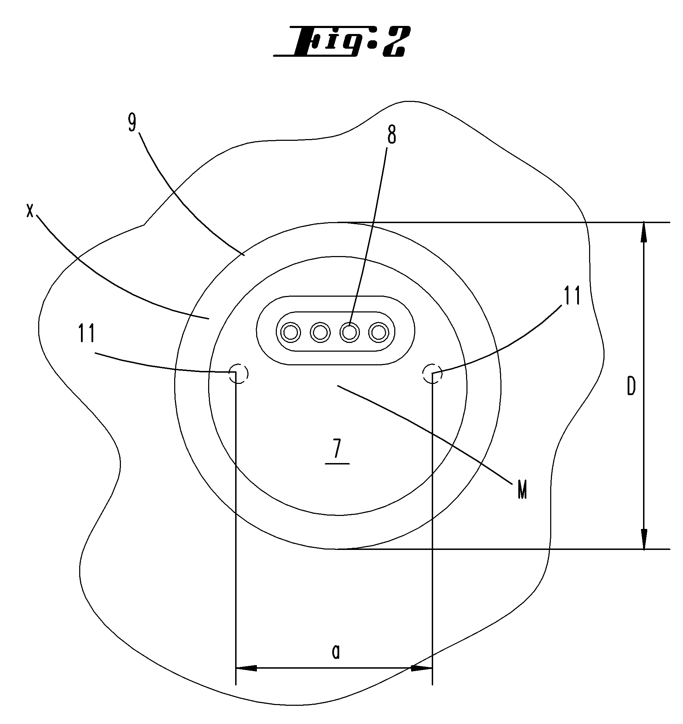

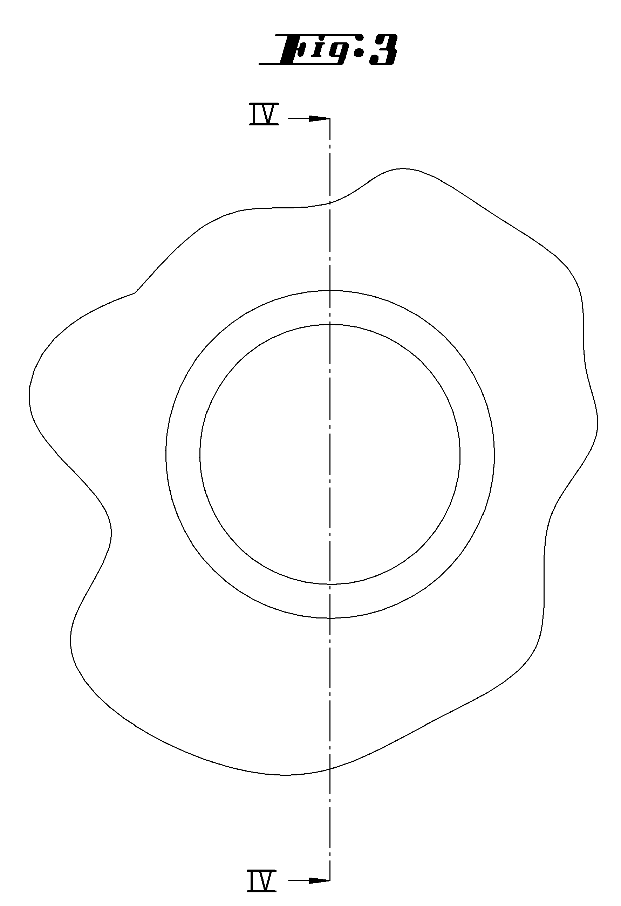

Die Teil-Außenfläche 7 ist mit Ausnahme eines Übergangsbereiches x in die umgebende Außenfläche 6 ebenflächig ausgebildet. Eine weitere Ausnahme können hierbei metallische Kontaktelemente 8 bilden, vergleiche Figur 2 beziehungsweise Figur 3. Die Teil-Außenfläche 7 ist gegenüber der genannten Außenfläche 6 der Küchenmaschine zurückversetzt. Innerhalb der Teil-Außenfläche 7 bilden die metallischen Kontaktelemente 8 einen Bereich dieser Teil-Außenfläche aus.

Die Teil-Außenfläche 7 ist bevorzugt als abgeschlossener Bereich ausgebildet. Dies ergibt sich beim Ausführungsbeispiel insbesondere durch eine geschlossen verlaufende Randkonturlinie 9. Die Randkonturlinie 9 muss nicht notwendig einer tatsächlichen Kante im Gehäuse entsprechen. Bevorzugt ist sie durch eine Kante gebildet. Sie kann etwa auch durch einen gerundeten Übergang (im Querschnitt) in die umgebende Außenfläche 6, also einer Sichtkante entsprechend, gegeben sein.

Die Teil-Außenfläche 7 ist weiter bevorzugt, wie sich insbesondere auch aus der Querschnittsdarstellung der Figur 3 ergibt, in einer Tiefenrichtung, zum Inneren der Küchenmaschine hin, geschlossen ausgebildet. Sie weist keine Durchbrüche, Öffnungen oder Vertiefungen in Richtung auf das Innere der Küchenmaschine auf. Sie stellt somit eine im Wesentlichen glatte, leicht reinigbare Fläche dar. Dem steht auch nicht entgegen, wenn die Kontaktelemente, wie nachstehend in weiterer Einzelheit erläutert, demgegenüber nochmals leicht angehoben oder abgesenkt angeordnet sind.

Die metallischen Kontaktelemente 8 sind zwar innerhalb der Absenkung der Teil-Außenfläche 7 angeordnet; gegenüber dem ebenflächigen Boden 10 der Teil-Außenfläche 7, der auch als Muldenboden angesprochen sein kann, sind sie jedoch bevorzugt leicht erhöht angeordnet.

Sie können auch ebenengleich oder etwas versenkt zu dem Boden 10 angeordnet sein, wie weiter vorne erläutert. Die Erhöhung ist bevorzugt (nur) in dem Maße, dass sie sich zwar erhöht zu dem umgebenden Bereich des Bodens 10 erstrecken, jedoch unterhalb der Randkonturlinie 9 beziehungsweise unterhalb eines umgebenden Flächenbereiches f der Außenfläche 6. Die Erhöhung ist in weiterer Einzelheit rippenartig gebildet. Die Kontaktflächen bilden Teilbereiche einer Stirnfläche einer solchen rippenartigen Erhöhung.

Es sind insgesamt bevorzugt vier metallische Kontaktelemente 8 vorgesehen, die auch bevorzugt auf einer Geraden nebeneinander angeordnet sind.

Die Teil-Außenfläche 7 ist, bezüglich ihrer Randkontur, beim Ausführungsbeispiel kreisförmig gebildet mit einem Flächenmittelpunkt M. Ein Durchmesser D entspricht beim Ausführungsbeispiel circa 4 cm.

Weiter sind zugeordnet dem Boden 10 der Teil-Außenfläche 7 Magnete 11 oder magnetisierbare Bereiche zugeordnet, die aber bevorzugt unterhalb des Bodens 10 und von außen weiter bevorzugt nicht sichtbar angeordnet sind.

Diese Magnete 11, oder magnetisierbaren Bereiche, wenn entsprechende Magnete in dem Datenspeicherelement vorgesehen sind, dienen zur Ausrichtung und Halterung des Datenspeicherelementes im mit der Küchenmaschine verbundenen Zustand.

Ein Abstand a zwischen den Magneten 11 ist bevorzugt größer als ein Abstand zwischen zwei äußersten der beim Ausführungsbeispiel vier, nebeneinander angeordneten metallischen Kontaktelemente 8.

Die Magnete 11 beziehungsweise entsprechende magnetisierbare Bereiche sind bevorzugt nahe der Randkontur der Teil-Außenfläche 7 jeweils angeordnet.

Die Magnete 11, oder magnetisierbaren Bereiche, und die Kontaktelemente befinden sich auch bevorzugt zusammengefasst in einem Flächenbereich, welcher einer Hälfte oder weniger der Gesamtfläche der Teil-Außenfläche 7 entspricht.

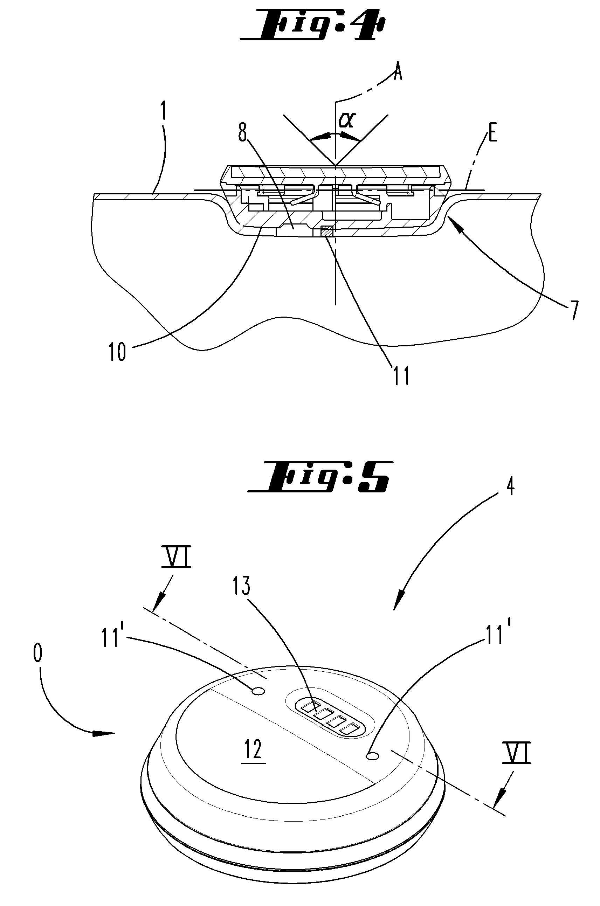

In den Figuren 4 bis 6 ist das Datenspeicherelement 4 in weiterer Einzelheit dargestellt.

Mit Bezug zu den Figur 5 und 7, 8 ist ersichtlich, dass es beim Ausführungsbeispiel einen kreisförmigen Grundriss aufweist, der aber auch beispielsweise ovalförmig oder unregelmäßig gerundet, hinsichtlich der Kontur gegebenenfalls mit geraden Zwischenabschnitten, gebildet sein kann.

Aus der auf der in Figur 5 oberen Seite, vorstehend auch als Unterseite angesprochen, weist das Datenspeicherelement 4 eine Anlagefläche 12 auf, mit der es im Verbindungszustand mit der Küchenmaschine 1 an der Teil-Außenfläche 7 anliegt. In der Anlagefläche 12 sind mehrere Kontaktflächen 13, beim Ausführungsbeispiel vier nebeneinander angeordnete Kontaktflächen 13, entsprechend den beschriebenen vier Kontaktflächen 8 an der Küchenmaschine, ausgebildet.

Entsprechend der leicht erhabenen Ausbildung des Bereiches, in welchem die Kontaktflächen 8 der Küchenmaschine angeordnet sind, sind die Kontaktflächen 13 des Datenspeicherelementes 4 in einem gegenüber der Anlagefläche 12 etwas versenkten Bereich angeordnet. Der versenkte Bereich ist nutartig gebildet. Hinsichtlich der Abmessungen wird auf die vorstehende Beschreibung auch der rippenartigen Erhöhung im Bereich der Teil-Außenfläche beziehungsweise der Außenfläche der Küchenmaschine verwiesen. Insofern ergibt sich eine komplementäre Gestaltung.

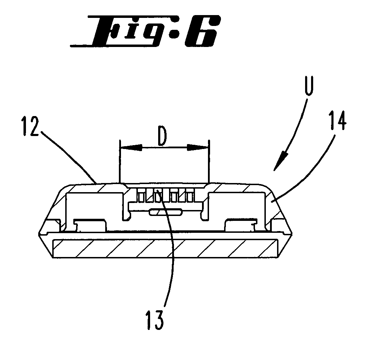

In weiterer Einzelheit, vergleiche Figuren 6 bis 8, setzt sich das Datenspeicherelement 4 aus einem als Deckelteil 14 bezeichneten Teil zusammen, in welchem die genannten Kontaktflächen 13 und die Anlagefläche 12 ausgebildet sind, einem Ringteil 15, einem Funktionsträgerteil 16 und einem Bodenteil 17. Auf dem Funktionsträgerteil 16, wobei aber auch eine andere Anordnung oder Befestigung innerhalb des Datenträgerelementes 4 möglich ist, sind beim Ausführungsbeispiel die elektronischen Bauteile, die für den Betrieb und die Nutzung des Datenspeicherelementes 4 erforderlich sind, angeordnet. Es handelt sich um Speicherelemente, insbesondere auch um einen Kryptospeicher, Leiterelemente und gegebenenfalls, in einer besonderen Ausführungsform, um Elemente, die zur Funkübertragung von Daten, etwa nach dem UMTS-Standard, erforderlich sind.

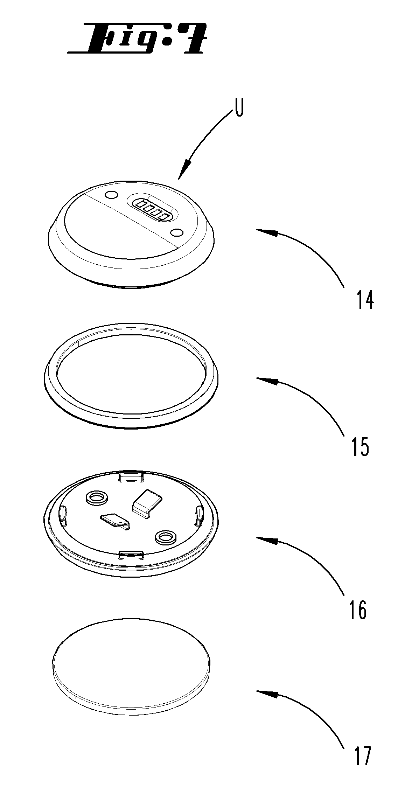

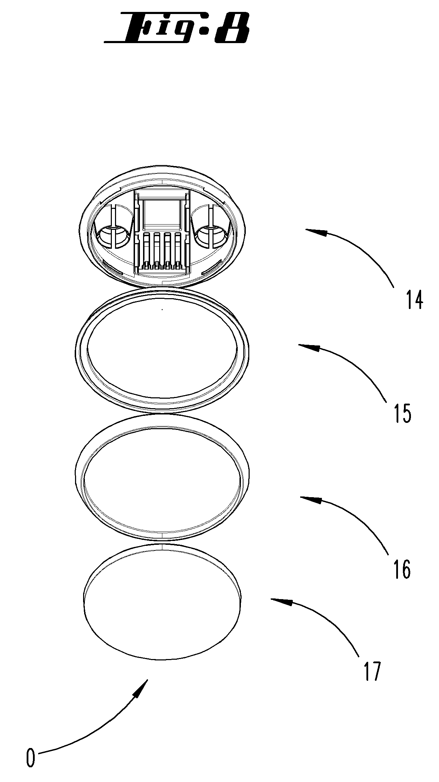

Aus der Darstellung der Figur 8, in der die Teile, die in Figur 7 sichtbar sind, von schräg unten dargestellt sind, ist ersichtlich, dass in dem Deckelteil 14 auch entsprechende Komponenten, insbesondere Leiterelemente und Leiterbahnen, zur Zusammenwirkung mit den elektronischen Komponenten, die im Funktionsträger 16 angeordnet sind, vorgesehen sind.

In dem Datenspeicherelement 4 sind auch, bevorzugt "spiegelbildlich" zu einer Ausbildung in der Außenfläche oder Teil-Außenfläche der Küchenmaschine 1 Magnete 11' oder magnetisierbare Bereiche ausgebildet.

Insgesamt ist das Datenspeicherelement 4 bevorzugt als Flachteil ausgebildet, mit einer Unterseite und einer Oberseite. Eine größte Grundrissabmessung der Unterseite beziehungsweise der Oberseite kann bevorzugt dem 1,5-Fachen oder mehr einer größten Dicke des Datenspeicherelementes 4 entsprechen. Die zweiten Kontaktelemente 13 sind bevorzugt in der Unterseite angeordnet. Bei an der Küchenmaschine zur Datenübertragung angeordnetem Speicherelement ist praktisch nur die Oberseite sichtbar (vergleiche Figur 3).

Die Sichtbarkeit der Oberseite kann dahingehend präzisiert werden, dass jedenfalls bezogen auf einen geraden Sichtkegel einer Kegelachse A, der sich senkrecht zu einer Mittelebene E erstreckt, in einem Kegelwinkel α von 60° oder weniger gegeben ist. Die Mittelebene E erstreckt sich ersichtlich quer zu einer Dickenerstreckung des Datenspeicherelementes 4 und bevorzugt parallel oder nahezu parallel zu der Oberseite des Datenspeicherelementes 4. Die Kegelachse A geht darüber hinaus bevorzugt durch den Flächenmittelpunkt M eines Grundrisses des Datenspeicherelementes.

Das Datenspeicherelement 4 weist in dem in Figur 4 dargestellten Kontaktzustand auch ein Griffteil auf. Das Griffteil ist hier durch die Gestaltung des Datenspeicherelementes 4 selbst gegeben, nämlich dadurch im Einzelnen, dass die Unterseite U teilweise über die umgebende Außenfläche 6 der Küchenmaschine 1 nach außen vorsteht und in eine umlaufende Kante K übergeht, von welcher beginnend die Oberseite O sich erstreckt. An der Kante K kann dann mit den Fingern einer Hand angreifend das Datenspeicherelement 4 aus der Küchenmaschine 1 wieder entnommen werden.

Ein Abstand u der Kante K über die umgebende Außenfläche 6 der Küchenmaschine 1 kann in Absolutwerten beispielsweise 0,5 bis 5 mm betragen.

Die Kante K ist bevorzugt durch das Zusammentreffen der sich im Querschnitt im Randbereich konusförmig nach oben beziehungsweise nach unten erstreckenden Randabschnitte der Konturlinie des Datenspeicherelementes gegeben. Sie ist bezüglich der Mittelebene E versetzt zur Oberseite O.

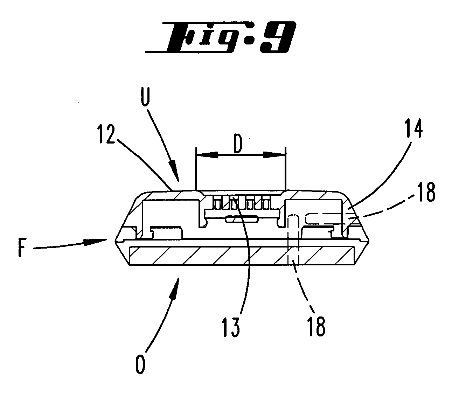

In Figur 9 ist angedeutet, dass das Datenspeicherelement 4 auch eine oder mehrere übliche, lochartig in das Innere des Datenspeicherelement 4 ragende USB-Schnittstellen 18 aufweisen kann. Bevorzugt ist nur eine übliche USB-Schnittstelle 18 am Datenspeicherelement bei dieser Ausgestaltung verwirklicht.

Eine solche USB-Schnittstelle 18 kann insbesondere ausgehend von der Oberseite O oder einer Seitenfläche F gebildet sein. Grundsätzlich kann sie aber auch von der Unterseite U ausgehend gebildet sein.

Eine solche übliche USB-Schnittstelle 18 kann, was im Einzelnen nicht dargestellt ist, mit einem Verschlussteil versehen sein, um beim üblichen Gebrauch eine Verschmutzung möglichst zu vermeiden. Das Verschlussteil kann stopfenartig ausgebildet sein. Es kann auch nur mit einem Werkzeug lösbar vorgesehen sein. Beispielsweise kann es mit dem Datenspeicherelement verschraubt sein.

**Bezugszeichenliste:**

| | | | |
|---|---|---|---|
| 1 | Küchenmaschine | A | Kegelachse |
| 2 | Rührgefäß | E | Mittelebene |
| 3 | Bedienfeld | K | Kante |
| 4 | Datenspeicherelement | M | Flächenmittelpunkt |
| 5 | Gehäuse | O | Oberseite |
| 6 | Außenfläche | U | Unterseite |
| 7 | Teil-Außenfläche | F | Seitenfläche |
| 8 | Kontaktelement | u | Abstand |
| 9 | Randkontur | x | Übergangsbereich |
| 10 | Boden | | |
| 11 | Magnet | | |
| 11' | Magnet | α | Kegelwinkel |
| 12 | Anlagefläche | | |
| 13 | Kontaktelement | | |
| 14 | Deckelteil | | |
| 15 | Ringteil | | |
| 16 | Funktionsträgerteil | | |
| 17 | Bodenteil | | |
| 18 | USB-Schnittstelle | | |

## Patentansprüche

1. Elektromotorisch betriebene Küchenmaschine (1) mit einem eine Außenfläche (6) aufweisenden Gehäuse (5) und einer zur Zusammenwirkung mit einem Datenspeicherelement (4) ausgebildeten Datenübertragungs-Schnittstelle, **dadurch gekennzeichnet, dass** die Datenübertragungs-Schnittstelle in einer Außenfläche (6) des Gehäuses (5) durch nebeneinander angeordnete metallische, jeweils eine Kontaktfläche aufweisende und jeweils einen Teil der Außenfläche darstellende Kontaktelemente (8) gebildet ist.

2. Datenspeicherelement (4) zum Übertragen von Daten auf eine elektromotorisch betreibbare Küchenmaschine (1) mit mehreren voneinander gesonderten Kontaktelementen und einer Anlagefläche, **dadurch gekennzeichnet, dass** die jeweils eine Kontaktfläche aufweisenden Kontaktelemente jeweils einen Teil der Anlagefläche (12) bilden und dass in der Anlagefläche (12) auch, gesondert von den Kontaktelementen, ein oder mehrere Magnete (11') wirken oder ein oder mehrere magnetisierbare Bereiche ausgebildet sind.

3. Kombination einer elektromotorisch betreibbaren Küchenmaschine (1) mit einem lösbar mit der Küchenmaschine (1) verbindbaren Datenspeicherelement (4), dessen Daten in eine mit der Küchenmaschine (1) verbundenen Zustand an die Küchenmaschine (1) übertragbar sind, wobei die Küchenmaschine (1) ein eine Außenfläche (6) aufweisendes Gehäuse (5) und eine zur Zusammenwirkung mit einem Datenspeicherelement (4) ausgebildete Datenübertragungs-Schnittstelle aufweist, **dadurch gekennzeichnet, dass** die Datenübertragungs-Schnittstelle in der Außenfläche (6) des Gehäuses (5) durch nebeneinander angeordnete metallische, jeweils eine Kontaktfläche aufweisende und hiermit jeweils einen Teil der Außenfläche (6) darstellende Kontaktelemente (8) gebildet ist, dass das Datenspeicherelement (4) eine zur flächigen Anlage an die Datenübertragungs-Schnittstelle der Küchenmaschine (1) dienende Anlagefläche aufweist, wobei jeweils eine Kontaktfläche aufweisende Kontaktelemente (8) jeweils einen Teil der Anlagefläche bilden.

4. Kombination aus einer elektromotorisch betriebenen Küchenmaschine (1) und einem als Einzelteil handhabbaren, mit der Küchenmaschine (1) für einen Datenaustausch kontaktierbaren Datenspeicherelement (4), wobei die Küchenmaschine (1) ein eine Außenfläche (6) aufweisendes Gehäuse (5) aufweist und eine zur Zusammenwirkung mit dem Datenspeicherelement (4) ausgebildete Datenübertragungs-Schnittstelle mit erstem Kontaktelement (8) und das Datenspeicherelement (4) zweite Kontaktelemente (8) aufweist, **dadurch gekennzeichnet, dass** das Datenspeicherelement (4) als Flachteil mit einer Unterseite und einer Oberseite ausgebildet ist, mit einer größten Grundrissabmessung der Unterseite beziehungsweise der Oberseite, die dem 1,5-Fachen oder mehr einer größten Dicke des Datenspeicherelementes (4) entspricht, dass die zweiten Kontaktelemente (8) in der Unterseite angeordnet sind und dass von dem mit der Küchenmaschine (1) zur Datenübertragung zusammenwirkendem Datenspeicherelement (4) nur die Oberseite sichtbar ist, wobei eine Ausrichtung der Oberseite angepasst ist an eine Ausrichtung der umgebenden Außenfläche (6).

5. Küchenmaschine oder Kombination nach einem der vorhergehenden Ansprüche, **dadurch gekennzeichnet, dass** die Außenfläche des Gehäuses im Bereich der Datenübertragungs-Schnittstelle als zum Inneren der Küchenmaschine zurückversetzte Teil-Außenfläche (7) ausgebildet ist, wobei, bevorzugt, die Teil-Außenfläche (7) abgeschlossen ausgebildet ist.

6. Küchenmaschine oder Kombination nach einem der vorhergehenden Ansprüche, **dadurch gekennzeichnet, dass** die metallischen Kontaktelemente (8) sich über die Ebene der Teil-Außenfläche (7) um ein ihrer größten Erstreckung entsprechendes Maß oder weniger erheben oder um ein solches Maß gegenüber der Ebene zurückversetzt sind und/ oder die metallischen Kontaktelemente (8) sich in der Ebene der Teil-Außenfläche (7) erstrecken.

7. Küchenmaschine oder Kombination nach einem der vorhergehenden Ansprüche, **dadurch gekennzeichnet, dass** drei oder mehr übliche Kontaktelemente (8) vorgesehen sind und/oder die metallischen Kontaktelemente (8) entlang einer Geraden angeordnet sind.

8. Küchenmaschine oder Kombination nach einem der vorhergehenden Ansprüche, **dadurch gekennzeichnet, dass** die Teil-Außenfläche (7) einen Flächenmittelpunkt (M) aufweist und dass die metallischen Kontaktelemente (8) außerhalb des Flächenmittelpunktes (M) angeordnet sind und/oder die Teil-Außenfläche (7) eine Rundungen aufweisende Grundkontur aufweist, wobei, bevorzugt, die Grundrisskontur kreisförmig ist oder die Grundrisskontur oval ist und/ oder eine größte Erstreckung der Grundrisskontur 1 bis 10 cm beträgt.

9. Küchenmaschine oder Kombination nach einem der vorhergehenden Ansprüche, **dadurch gekennzeichnet, dass** ein oder mehrere in der Teil-Außenfläche (7) wirksamer Magnet (11) oder Magnete vorgesehen sind und/ oder, dass in der Teil-Außenfläche (7) ein oder mehrere magnetisierbare Bereiche vorgesehen sind und/ oder, dass ein Magnet (11) seitlich versetzt zu einem metallischen Kontaktelement (8) vorgesehen ist und/oder, dass ein Magnet (11) unterhalb der Teil-Außenfläche (7) angeordnet ist und/oder, dass ein Magnet (11) von außen unsichtbar ist.

10. Küchenmaschine oder Kombination nach Anspruch 9, **dadurch gekennzeichnet, dass** zwei Magnete (11) vorgesehen sind.

11. Küchenmaschine oder Kombination nach einem der Ansprüche 9 oder 10, **dadurch gekennzeichnet, dass** ein Abstand zwischen den Magneten (11) größer ist als ein Abstand zwischen zwei äußersten von nebeneinander angeordneten metallischen Kontaktelementen (8).

12. Küchenmaschine, Datenspeicherelement oder Kombination nach einem der vorhergehenden Ansprüche, **dadurch gekennzeichnet, dass** das Datenspeicherelement (4) einen nicht flüchtigen Speicher aufweist.

13. Küchenmaschine, Datenspeicherelement oder Kombination nach einem der vorhergehenden Ansprüche, **dadurch gekennzeichnet, dass** das Datenspeicherelement (4) einen Kryptospeicher aufweist.

14. Küchenmaschine, Datenspeicherelement oder Kombination nach einem der vorhergehenden Ansprüche, **dadurch gekennzeichnet, dass** das Datenspeicherelement (4) mit Ausnahme der jeweils einen Teil der Außenfläche bildenden metallischen Kontaktelemente keine Schnittstellenelemente aufweist.

15. Küchenmaschine, Datenspeicherelement oder Kombination nach einem der Ansprüche 1 bis 13, **dadurch gekennzeichnet, dass** zusätzlich zu den metallischen Kontaktelementen an dem Datenspeicherelement (4) eine Standard-USB-Schnittstelle (18) ausgebildet ist.

## Claims

1. A kitchen appliance (1) operable by electric motor, comprising a housing (5), which has an outer surface (6) and comprising a data transmission interface designed to interact with a data memory element (4), **characterized in that** the data transmission interface is formed in an outer surface (6) of the housing (5) by metal contact elements (8), which are arranged adjacent to each other and which each have a contact surface and form part of the outer surface.

2. A data memory element (4) for transmitting data to a kitchen appliance (1) operable by electric motor, comprising a plurality of contact elements that are separate from each other and comprising a bearing surface, **characterized in that** the contact elements, which each have a contact surface, each form part of the bearing surface (12) and that one or a plurality of magnets (11') also act in the bearing surface (12), separate from the contact elements (8), or that one or a plurality of magnetizable areas are embodied.

3. A combination of a kitchen appliance (1) operable by electric motor, comprising a data memory element (4), which can be detachably connected to the kitchen appliance (1) and the data of which can be transmitted to the kitchen appliance (1) while the data memory element (4) is connected to the kitchen appliance (1), wherein the kitchen appliance (1) comprises a housing (5), which has an outer surface (6), and comprising a data transmission interface designed to interact with a data memory element (4), **characterized in that** the data transmission interface is formed in the outer surface (6) of the housing (5) by metal contact elements (8), which are arranged adjacent to each other and which each have a contact surface and form part of the outer surface (6), that the data memory element (4) has a bearing surfaces, which serves to bear flat against the data transmission interface of the kitchen appliance (1), wherein contact elements (8), which each have a contact surface, each form part of the bearing surface.

4. A combination of a kitchen appliance (1) operable by electric motor and a data memory element (4), which can be handled as an individual part and which can be brought into contact with the kitchen appliance (1) for data exchange, wherein the kitchen appliance (1) has a housing (5), which has an outer surface (6) and comprising a data transmission interface designed to interact with the data memory element (4), comprising first contact element (8) and the data memory element (4) has second contact elements (8), **characterized in that** the data memory element (4) is designed as flat part comprising a bottom side and an upper side, comprising a largest layout dimension of the bottom side or of the upper side, respectively, which corresponds to 1.5-times or more of a largest thickness of the data memory element (4), that the second contact elements (8) are arranged in the bottom side and that only the upper side of the data memory elements (4), which interact which the kitchen appliance for data transmission, is visible, wherein an orientation of the upper side is adapted to an orientation of the surrounding outer surface (6).

5. The kitchen appliance or combination according to one of the preceding claims, **characterized in that**, in the area of the data transmission interface, the outer surface of the housing is designed as partial outer surface (7), which is offset towards the interior of the kitchen appliance, wherein the partial outer surface (7) is preferably designed so as to be closed.

6. The kitchen appliance or combination according to one of the preceding claims, **characterized in that** the metal contact elements (8) rise beyond the plane of the partial outer surface (7) by a measure, which corresponds to the largest extension thereof, or less, or are shifted back by such a measure relative to the plane and/or the metal contact elements (8) extend in the plane of the partial outer surface (7).

7. The kitchen appliance or combination according to one of the preceding claims, **characterized in that** provision is made for three or more common contact elements (8) and/or the metal contact elements (8) are arranged along a straight line.

8. The kitchen appliance or combination according to one of the preceding claims, **characterized in that** the partial outer surface (7) has an area center (M) and that the metal contact elements (8) are arranged outside of the area center (M) and/or the partial outer surface (7) has a layout contour, which has curves, wherein the layout contour is preferably circular or the layout contour is oval and/or a largest extension of the layout contour is between 1 and 10 cm.

9. The kitchen appliance or combination according to one of the preceding claims, **characterized in that** provision is made for one magnet (11) or for a plurality of magnets, which are active in the partial outer surface (7) and/or that provision is made in the partial outer surface (7) for one or a plurality of magnetizable areas and/or a magnet (11) is provided laterally offset to a metal contact element (8) and/or that a magnet (11) is arranged below the partial outer surface (7) and/or a magnet (11) is invisible from outside.

10. The kitchen appliance or combination according to claim 9, **characterized in that** provision is made for two magnets (11).

11. The kitchen appliance or combination according to one of claims 9 or 10, **characterized in that** a distance between the magnets (11) is larger than a distance between two outermost metal contact elements (8), which are arranged adjacent to each other.

12. The kitchen appliance, data memory element or combination according to one of the preceding claims, **characterized in that** the data memory element (4) has a non-volatile memory.

13. The kitchen appliance, data memory element or combination according to one of the preceding claims, **characterized in that** the data memory element (4) has a cryptographic memory.

14. The kitchen appliance, data memory element or combination according to one of the preceding claims, **characterized in that**, with the exception of the metal contact elements, which each form part of the outer surface, the data memory element (4) does not have any interface elements.

15. The kitchen appliance, data memory element or combination according to one of claims 1 to 13, **characterized in that** a standard USB interface (18) is embodied in addition to the metal contact elements at the data memory element (4).

## Revendications

1. Robot de cuisine (1) à moteur électrique, comprenant un boîtier (5) présentant une surface extérieure (6) et une interface de transfert de données pour coopérer avec un élément de stockage de données (4), **caractérisé en ce que** l'interface de transfert de données est formée dans une surface extérieure (6) du boîtier (5) par des éléments de contact métalliques (8) agencés côte à côte lesquels présentent chacun une surface de contact et forment chacun une partie de la surface extérieure.

2. Elément de stockage de données (4) pour le transfert de données à un robot de cuisine (1) à moteur électrique, comprenant plusieurs éléments de contact séparés les uns des autres et une surface d'appui, **caractérisé en ce que** les éléments de contact présentent chacun une surface de contact et forment chacun une partie de la surface d'appui (12) et qu'aussi un ou plusieurs aimants (11') sont actifs dans la surface d'appui (12) ou qu'y sont formés une ou plusieurs régions magnétisables, lesquels aimants ou régions magnétisables sont séparés des éléments de contact.

3. Combinaison d'un robot de cuisine (1) à moteur électrique avec un élément de stockage de données (4) apte à être relié de manière amovible avec le robot de cuisine (1) et dont les données peuvent, dans un état lié au robot de cuisine (1), être transférées au robot de cuisine (1), dans laquelle le robot de cuisine (1) comprend un boîtier (5) présentant une surface extérieure (6) et une interface de transfert de données pour coopérer avec un élément de stockage de données (4), **caractérisé en ce que** l'interface de transfert de données est formée dans une surface extérieure (6) du boîtier (5) par des éléments de contact métalliques (8) agencés côte à côte lesquels présentent chacun une surface de contact et formant avec celle-ci une partie de la surface extérieure (6), **en ce que** l'élément de stockage de données (4) présente une surface d'appui destinée à l'appui surfacique contre l'interface de transfert de données du robot de cuisine (1), dans laquelle des éléments de contact (8) présentant chacun une surface de contact, forment chacun une partie de la surface d'appui.

4. Combinaison d'un robot de cuisine (1) à moteur électrique et d'un élément de stockage de données (4) qui peut être manipulé en tant que pièce individuelle et qui apte à être mis en contact avec le robot de cuisine (1) aux fins d'échange de données, dans laquelle le robot de cuisine comprend un boîtier (5) présentant une surface extérieure (6) et une interface de transfert de données conçue pour coopérer avec l'élément de stockage de données (4) laquelle a un premier élément de contact (8) et l'élément de stockage de données (4) présente des deuxièmes éléments de contact (8), **caractérisé en ce que** l'élément de stockage de données (4) est réalisé sous la forme d'un élément plat ayant un côté inférieur et un côté supérieur et dont la dimension planimétrique maximale du côté inférieur, respectivement du côté supérieur, correspond à 1,5 fois ou plus d'une épaisseur maximale de l'élément de stockage de données (4), **en ce que** les deuxièmes éléments de contact (8) sont agencés dans le côté inférieur et **en ce que** seul soit visible le côté supérieur de l'élément de stockage de données (4) coopérant avec le robot de cuisine (1) pour transférer des données, dans laquelle une orientation du côté supérieur est adaptée à une orientation de la surface extérieure avoisinante (6).

5. Robot de cuisine ou combinaison selon l'une des revendications précédentes, **caractérisé en ce que** la surface extérieure du boîtier est réalisée dans la région de l'interface de transfert de données sous forme de surface extérieure partielle (7) en retrait vers l'intérieur du robot de cuisine, la surface extérieure partielle (7) étant préférentiellement réalisée de manière à être fermée.

6. Robot de cuisine ou combinaison selon l'une des revendications précédentes, **caractérisé en ce que** les éléments de contact métallique (8) s'élèvent au-dessus du plan de la surface extérieure partielle (7) d'une distance correspondant à leur extension maximale ou moins ou sont disposés en retrait d'une telle distance par rapport au plan et/ou les éléments de contact métalliques (8) s'étendent dans le plan de la surface extérieure partielle (7).

7. Robot de cuisine ou combinaison selon l'une des revendications précédentes, **caractérisé en ce que** sont prévus trois éléments de contact classiques (8) ou plus et/ou les éléments de contact métalliques sont agencés le long d'une droite.

8. Robot de cuisine ou combinaison selon l'une des revendications précédentes, **caractérisé en ce que** la surface extérieure partielle (7) présente un point central de surface (M) et que les éléments de contact métalliques sont agencés en dehors du point central de surface (M) et/ou la surface extérieure partielle (7) présente un contour de base présentant des arrondis, dans lequel préférentiellement le contour planimétrique est en forme de cercle ou le contour planimétrique est ovale et/ou une extension maximale du contour planimétrique est de 1 à 10 cm.

9. Robot de cuisine où combinaison selon l'une des revendications précédentes, **caractérisé en ce que** sont prévus un ou plusieurs des aimants (11) actifs dans la surface extérieure partielle (7) et/ou **en ce que** sont prévus une ou plusieurs régions magnétisables dans la surface extérieure partielle (7) et/ou **en ce qu'**est prévu un aimant (11) décalé latéralement par rapport à un élément de contact métallique (8) et/ou **en ce qu'**est agencé un aimant (11) sous la surface extérieure partielle (7) et/ou **en ce qu'**un aimant (11) est invisible depuis l'extérieur.

10. Robot de cuisine ou combinaison selon la revendication 9, **caractérisé en ce que** sont prévus deux aimants (11).

11. Robot de cuisine ou combinaison selon l'une des revendications 9 ou 10, **caractérisé en ce que** l'écartement de deux aimants (11) est supérieur à l'écartement des deux éléments les plus extérieurs parmi des éléments de contacts métalliques (8) agencés côte à côte.

12. Robot de cuisine, élément de stockage de données ou combinaison selon l'une des revendications précédentes, **caractérisé en ce que** l'élément de stockage de données (4) comprend une mémoire non volatile.

13. Robot de cuisine, élément de stockage de données ou combinaison selon l'une des revendications précédentes, **caractérisé en ce que** l'élément de stockage de données (4) comprend une mémoire cryptographique.

14. Robot de cuisine, élément de stockage de données ou combinaison selon l'une des revendications précédentes, **caractérisé en ce que** l'élément de stockage de données (4) ne comprend pas d'élément d'interfaçage autre que les éléments de contact métalliques formant chacun une partie de la surface extérieure.

15. Robot de cuisine, élément de stockage de données ou combinaison selon l'une des revendications 1 à 13, **caractérisé en ce que**, en plus des éléments de contact métalliques, une interface USB standard (18) est agencée sur l'élément de stockage de données (4).
